# EUROPEAN PATENT APPLICATION

(11) **EP 1 708 024 A2**
(43) Date of publication of application: **04.10.2006**
(21) Application number: 06005511.8
(22) Date of filing: 17.03.2006
(51) Int. Cl.: G03F 7/004, G03F 7/00

(54) **Photosensitive thick-film dielectric paste composition and method for making an insulating layer using same**

(30) Priority: 01.04.2005 US 96464
(71) Applicant: E.I. du Pont de Nemours and Company, Wilmington, DE 19898 (US)
(72) Inventor: Tsutomu, Mutoh, Tochigi Utsunomiya City 321-0846 (JP)
(74) Representative: Towler, Philip Dean

(57) **Abstract**

Disclosed is a photosensitive thick-film dielectric paste composition that includes a glass frit having a glass softening point not lower than 0° to 40°C below a firing temperature ranging above 450°C and up to 600°C; an organic polymer binder; a photoinitiator; a photocurable monomer; and an organic solvent, wherein the composition is aqueous-developable upon exposure to actinic radiation. A method for forming an insulating layer using the composition is also provided.

## Description

### FIELD OF THE INVENTION

The present invention relates generally to photosensitive thick-film dielectric paste compositions, and more specifically to photosensitive thick-film dielectric paste compositions for forming a dielectric layer in electronic devices.

### TECHNICAL BACKGROUND INFORMATION

Two types of flat panel displays have attracted much attention in recent years. In one type of device (fluorescent emission), an emitter made of an electron-emitting material is disposed between a cathode conductor and a gate electrode. A voltage applied between the cathode conductor and the gate electrode causes the emitter to emit electrons. A phosphor-coated anode electrode is provided opposite the electron emission source. The gate electrode and the anode electrode are driven at a predetermined positive potential, whereupon the electrons emitted by the electron emission source excite the phosphors, causing light emission and display.

In a second type of device (plasma), raised areas that serve as electrodes or barriers are formed on a front glass substrate and a back glass substrate. The two panels are placed opposite each other, sealed around the perimeter, and filled with an inert gas. Based on picture signals, a voltage is applied across the electrodes, inducing (in selected cells) a gas discharge that causes the phosphor layer to emit light, and resulting in the display of an image.

Glass dielectric paste is used for insulating the electrodes in both types of the above flat-panel displays. For example, in fluorescent emission-type displays, the gate electrode is formed with silver paste on the substrate by screen-printing and drying steps. A glass-based dielectric paste is then formed on top thereof by screen printing and drying steps, followed by firing in air at 500°C to 600°C for a period of several tens of minutes, thereby producing a field emission-type electron emission source. In plasma displays, silver electrodes may be formed on a front glass substrate. The electrodes may be also transparent and composed of silver. The electrodes are covered with a transparent dielectric protective layer of dielectric glass and magnesium oxide that is formed from a glass powder.

Further improvements in performance of these devices are being made by providing a transparent barrier rib structure over a transparent dielectric layer. The transparent barrier rib structure is formed by sandblasting away the insulator layer. For example, U.S. Patent No. 5,985,460 to Wang et al., discloses a green tape used in the formation of a barrier-rib for a plasma display apparatus whereby the green tape upon firing forms an amorphous, non-crystallizable glass and wherein the green tape composition consists essentially of: (a) an inorganic fine powder comprising based on total volume of the inorganic powder (i) 30 to 60 vol % of an amorphous, non-crystallizable glass, (ii) 20 to 70 volume % of a refractory oxide, and (iii) 0-50 vol % refractory pigment; wherein the glass has a softening point at least 50°C (and preferably 100°C) lower than the firing temperature range of 400°C-650°C for the green tape composition, and (b) a binder of 40 to 60 vol. % polymer and 40 to 60 vol. % of a plasticizer.

There remains a need for a photosensitive thick-film dielectric paste compositions for use in forming dielectric layers in display devices.

### SUMMARY OF THE INVENTION

In one embodiment, a photosensitive thick-film dielectric paste composition, includes: (a) a glass frit having a glass softening point not lower than 0° to 40°C below a firing temperature ranging above 450°C and up to 600°C; (b) an organic polymer binder; (c) a photoinitiator; (d) a photocurable monomer; and, (e) an organic solvent, wherein the composition is aqueous-developable upon exposure to actinic radiation.

In another embodiment, a method for forming an insulating layer in a display panel includes the steps of: providing a glass substrate; coating the substrate with a conductive thick film composition; firing the substrate and conductive composition to form an electrode; printing a dielectric paste composition comprising a glass frit onto a surface of the electrode; imagewise exposing selected areas of the dielectric composition with actinic radiation to form exposed and unexposed areas; developing the unexposed areas in an aqueous medium; and firing the exposed dielectric paste composition at a temperature ranging above 450°C and up to 600°C , wherein the glass softening point of the glass frit is not less than 0°C to 40°C below the firing temperature.

In another embodiment, an insulating layer is formed by the above method.

In another embodiment, a flat panel display includes the above composition.

In another embodiment, a flat panel display includes an insulating layer formed according to the above method.

Other features and advantages will be apparent from the following detailed description, and from the claims.

### DETAILED DESCRIPTION OF THE INVENTION

In one embodiment, a photosensitive thick-film dielectric paste composition, includes: (a) a glass frit having a glass softening point not lower than 0° to 40°C below a firing temperature ranging above 450°C and up to 600°C; (b) an organic polymer binder; (c) a photoinitiator; (d) a photocurable monomer; and, (e) an organic solvent, wherein the composition is aqueous-developable upon exposure to actinic radiation. The glass frit may include, based on mole percent, 66% PbO, 23% SiO₂, 8.5% B₂O₃, and 2.5% Al₂O₃. The glass frit may also be lead-free. The composition is developable in a solution including sodium carbonate. The glass softening point of the glass frit is 5°C to 20°C below the firing temperature. The firing temperature is between 500°C to 600°C and in one embodiment is between 520°C to 540°C.

In another embodiment, a method for forming an insulating layer in a display panel includes the steps of: providing a glass substrate; coating the substrate with a conductive thick film composition; firing the substrate and conductive composition to form an electrode; printing a dielectric paste composition comprising a glass frit onto a surface of the electrode; imagewise exposing selected areas of the dielectric composition with actinic radiation to form exposed and unexposed areas; developing the unexposed areas in an aqueous medium; and firing the exposed dielectric paste composition at a temperature ranging above 450°C and up to 600°C, wherein the glass softening point of the glass frit is not lower than 0°C to 40°C below the firing temperature. The glass frit may include, based on mole percent, 66% PbO, 23% SiO₂ 8.5% B₂O₃, and 2.5% Al₂O₃. The glass frit may also be lead-free. The aqueous medium includes a solution of 0.4 to 1.0 wt % sodium carbonate. The glass softening point of the glass frit may be 5°C to 20°C below the firing temperature. The step of firing may include firing the composition between 500°C to 600°C and also between 520°C to 540°C. The dielectric paste composition after firing may have a thickness of 20 µm.

In another embodiment, an insulating layer is formed by the method. The layer has a thickness of 20 µm after firing. The layer may be transparent.

In still another embodiment, a flat panel display includes the above composition. In another embodiment, a flat panel display includes an insulating layer formed according to the above method.

A photosensitive thick-film dielectric paste composition, which advantageously resolves problems associated with surface roughness of a dielectric glass layer, visible light transmittance, and decreased dielectric strength, is used to form a dielectric glass layer by photolithographic patterning followed by firing for use in display devices is hereafter described in detail.

The above photosensitive thick-film dielectric paste composition, which is patterned using photolithography, then fired to effect sintering to form a dielectric layer, is useful for forming a dielectric glass layer in the manufacture of display devices, such as flat panel displays. It has been found, in the photolithographic patterning of a dielectric glass layer formed of the photosensitive thick-film dielectric paste composition of the invention, that the relationship between the glass softening point and the firing temperature influences the properties of the dielectric layer.

For example, when the firing temperature is lower than the glass softening point, the surface of the dielectric glass layer becomes rough due to inadequate softening behavior, and thereby causes the irregular reflection of visible light. Under such low-firing temperature conditions, innumerable tiny voids may also be present in the dielectric film, which lead to the formation of pinholes and other defects. As a result of such problems, the visible light transmittance in the resulting dielectric layer is decreased, and film defects causing dielectric breakdown lower the dielectric strength.

In addition, it has been found that when the firing temperature is greater than 40°C to 80°C above the glass softening point, bubbles are formed in the dielectric layer thereby lowering the visible light transmittance and the dielectric strength. Under such high-temperature firing conditions (although a completely de-aerated zone may be achieved in which a transparent dielectric layer can be formed), the viscosity of the dielectric glass decreases, resulting in a marked decline in shape stability. High-temperature firing conditions may also promote reaction with the electrode material. In addition to the constraints imposed by the dielectric material, an additional problem has been the inability to achieve sufficient resolution and aspect ratios in pattern printing using screen-printing techniques.

By using a glass frit having a softening point not lower than 0°C to 40°C below the firing temperature of the composition, which ranges between 450°C to 600°C, the dielectric glass layer that is formed in the firing step can be conferred with surface planarity, the irregular reflection of visible light can be suppressed to enhance the transmittance of visible light, high-precision, high-aspect pattern formation can be achieved, and layer defects such as bubbles which induce dielectric breakdown can be minimized to improve dielectric strength.

### Inorganic Components

### Glass Frit

To achieve sufficient hermeticity in the dielectric layer, the glass frit has a glass softening point (Ts) which, in one embodiment, is from 0°C up to and including 40°C below the firing temperature, and, in another embodiment, is from 5°C up to and including 20°C below the firing temperature. As examples of deformation points, a glass substrate may be 600°C, and a soda lime glass substrate may be 540°C. The firing temperature would thus be between the deformation point of one of the above substrates and the volatization point of the organic binder used in the composition. It has been found that if softening occurs at a temperature below the range of 400°C to 450°C, the organic components that are generated in the firing step become trapped within the dielectric film that forms, creating bubbles within the dielectric layer or a tendency toward black discoloration due to carbonization.

In one embodiment, the glass frit includes lead borosilicate frits and borosilicate frits containing bismuth, cadmium or an alkaline earth compound such as barium or calcium. The production of the glass frit may involve, for example, dissolving oxides of the above elements together with glass components, and pouring the substances into water to form a frit solution. The batch components may be substances that provide the desired oxides under conventional frit formation conditions. For example, boron oxide can be obtained from boric acid, silicon dioxide can be obtained from flint, and barium oxide can be obtained from barium carbonate. In another embodiment, the glass frit does not contain any lead components. The glass frit content, based on the weight of the total composition, may suitably be 30 to 80 wt. %.

The glass is ground together with water in a vibratory mill to reduce the particle size of the frit, and to provide a frit of substantially uniform size. Because the solid components should be kept from forming agglomerated masses, the frit may be passed through a fine screen to remove large particles. A suitable surface area/weight ratio and particle size for the glass frit is not more than 10 m²/g and a 50 percent particle size (d₅₀) of 0.6 to 2.0 µm.

Within the above particle size and surface area limits, a d₅₀ of 0.8 to 1.2 µm is particularly useful because small particles having a high surface area readily adsorb inorganic materials that tend to hinder clean decomposition. In addition, a particle size larger than a d₅₀ of 0.8 to 1.2 µm tends to diminish the sintering properties.

### Inorganic Additives

In one embodiment of a dielectric layer that does not require transparent properties, an inorganic powder may be used as a filler. Examples of suitable inorganic powders include aluminum and silica.

### Organic Components

### Organic Vehicle

The organic vehicle is a medium for dispersing the finely ground solids of the composition in a form that can easily be applied onto a glass or other suitable substrate. Accordingly, the organic vehicle must, first of all, allow the above solids to stably disperse therein. Secondly, the rheological properties of this organic vehicle must impart good coatability characteristics to the dispersion.

When the dispersion is to be formed into a film, the organic vehicle in which the glass frit (inorganic binder) is dispersed includes, but is not limited to: a volatile organic solvent, a polymer binder, a monomer and an initiator. The organic vehicle may also include other materials such as plasticizers, parting agents, dispersants, stripping agents, antifouling agents and wetting agents.

To obtain a complete dispersion, the solvent component (which may be a mixture of a plurality of solvents) of the organic vehicle, may be selected so that, with the application of a relatively low level of heat at atmospheric pressure, the organic solvent will evaporate from the dispersion. In addition, the solvent must boil at a temperature sufficiently lower than the boiling point and degradation temperatures of other additives that may be included in the organic vehicle. A suitable solvent with a boiling point under atmospheric pressure of less than 150°C can suitably be used. Examples of suitable solvents include benzene, acetone, xylene, methanol, ethanol, methyl ethyl ketone, 1,1,1-trichloroethane, tetrachloroethylene, amyl acetate, 2,2,4-triethylpentanediol-1, 3-monoisobutyrate, toluene, methylene chloride, ethylene glycol monoalkyl ethers such as ethylene glycol mono-n-propyl ether, and ethylene glycol dialkyl ethers. For casting the composition as a film, methylene chloride is particularly useful in view of its volatility.

One or more plasticizer(s) for lowering the Tg of the polymer binder may also be included in the organic vehicle. The addition of a plasticizer helps ensure good lamination to a substrate and increases the developability of unexposed areas of the composition. However, to reduce the amount of organic materials which must be removed when a film cast from the composition is fired, the use of a plasticizer should be kept to a minimum. Selection of a suitable plasticizer is determined primarily by the polymer binder selected.

Plasticizers that may be suitably used include: diethyl phthalate, dibutyl phthalate, butyl benzyl phthalate, dibenzyl phthalate, alkyl phosphate, polyalkylene glycols, glycerol, poly(ethylene oxide), hydroxyethylated alkyl phenols, tricresyl phosphate, triethylene glycol diacetate and polyester. Dibutyl phthalate can be used effectively and at a relatively low concentration in acrylic polymer systems.

The photosensitive composition of the invention may also be used in the form of a photosensitive resist layer covering a base film layer. The photosensitive composition may be applied onto the supporting base film layer in an amount such that the thickness as a dry coat becomes 0.001 inch (about 0.0025 cm) to 0.01 inch (about 0.025 cm). Suitable base film layers which have a high dimensional stability to temperature changes may be selected from a broad range of film types, including those made of high molecular weight polymers such as polyamides, polyolefins, polyesters, vinyl polymers and cellulose esters. The base film layer may have a thickness of 0.005 inch (about 0.0013 cm) to 0.008 inch (about 0.02 cm) or more.

To prevent blocking between the resist layer and the surface of the base film layer when stored in the form of a roll, the resist layer may be protected with a removable cover sheet. A suitable removable cover sheet may be selected for use from the same group of high-molecular-weight polymer films used for the above-mentioned base film layers, and may have a similarly broad range of thicknesses. A polyethylene cover sheet having a thickness of 0.001 inch (about 0.0025 cm) is suitable for use. The above-described supporting base films and cover sheets provide good protection for the photosensitive resist layer during storage and prior to use.

To prevent blocking between the photosensitive layer laminated on the base film layer and the exposure tool during imagewise exposure, a removable supporting film may be used to protect the base film layer. If exposure is to be carried out prior to removing the removable supporting film, the supporting film must allow most of the actinic light irradiated thereon to pass through. Suitable supporting films include transparent polyethylene terephthalate films having a thickness of 0.001 inch (about 0.0025 cm).

To prevent blocking with the photosensitive resist layer when no removable cover sheet is provided and the resist layer is stored in the form of a roll, a thin release layer of a material such as wax or silicone may be applied to the backside of the peelable base film layer. Alternatively, tackiness to the photosensitive cover layer can be increased by flame treating or electrical discharge treating the support surface to be covered.

The weight ratio of the inorganic solids to the organic components may be within a range of 2.0 to 6.0, and also within a range of 2.6 to 4.5. To obtain sufficient dispersion and rheological properties, a ratio of not more than 6.0 is necessary. However, at less than 2.5, the amount of organic components that must be burned off becomes too high, thereby compromising the quality of the final layer. The ratio of inorganic solids to the organic components depends upon the particle size of the inorganic solids and on the organic component and also upon the surface preparation treatment of the inorganic solids.

When the particles are treated with an organosilane coupling agent, the ratio of inorganic solids to the organic components may be increased. To minimize firing defects, however, it is preferable to use a low level of organic components. Organosilanes preferable for use in the invention are generally those corresponding to the general formula RSi(OR')₃. In the formula, R' is methyl or ethyl, and R may be selected from methacryloxypropyl, polyalkylene oxide and other organic functional groups which interact with the organic matrix of the film.

When the dispersion is to be applied as a thick-film paste composition, a suitable thick-film organic vehicle may be used with a suitable rheological regulator, or a low-volatility solvent may be used. When the composition is formulated as a thick-film paste composition, a conventional method of application includes screen-printing. Therefore, the composition must be given a suitable viscosity to be capable of passing readily through the screen. Although the rheological characteristics are to be considered in formulating the composition, the composition is also formulated for thorough wetting of the solids by the organic vehicle, for an acceptable drying speed, for coating the substrate, for providing a dry film strength sufficient to withstand rough handling, and for good fireability. A composition of satisfactory appearance (when fired) is also a desirable characteristic.

In view of the above criteria, use can be made of a broad range of suitable inert liquids as the organic vehicle. Many organic vehicles for thick-film compositions include a resin dissolved in a solvent to form a solution. Suitable solvents boil in a range of 130°C to 350°C.

Resins particularly suitable for this purpose are the polymethacrylates of lower alcohols, and monobutyl ethers of the acid-bearing portions of ethylene glycol monoacrylates. Solvents that may also be used for thick-film coating include terpenes such as α- and β-terpineol, and mixtures of these with other solvents such as kerosene, dibutyl phthalate, butyl carbitol, butyl carbitol acetate, hexamethylene glycol and high-boiling alcohols or alcohol esters. Various combinations of these and other solvents are formulated to obtain a suitable viscosity and volatility required for coating. Accordingly, the final composition may be thixotropic, or it may, depending on the additives included in the composition, have Newtonian characteristics.

The ratio of organic vehicle to the inorganic solids in the dispersion can be considerably varied according to the method of applying the dispersion and the type of organic vehicle used. To achieve a good coat, the dispersion generally will include, complementary amounts, that is, 50 to 90 wt. % of solids and 50 to 10 wt % of organic vehicle. This type of dispersion is generally a viscous semifluid referred to as a "paste."

The paste may be conveniently prepared on a three-roll mill. The paste viscosity will typically be in a range below that during measurement. The amount and type of organic vehicle used is determined primarily from the final desired concentration of the preparation and from the print thickness selected.

### Aqueous Polymer Binder

Aqueous polymer binders can be broadly divided into alkali-processable and water-processable binders, depending on the selection of the resin ingredients in the organic components. Alkali-processable polymer binders are copolymers or interpolymers of C₁₋₁₀ alkyl acrylates or C₁₋₁₀ [alkyl] methacrylates with ethylenically unsaturated carboxylic acid-containing sites. Such sites account for at least 16%, and preferably 20 to 30%, of the polymer weight. The carboxylic acids include ethylenically unsaturated monocarboxylic acids, such as acrylic acid, methacrylic acid and crotonic acid; ethylenically unsaturated dicarboxylic acids such as fumaric acid, itaconic acid, citraconic acid, vinylsuccinic acid and maleic acid; as well as half-esters thereof and, if suitable, anhydrides and mixtures of the above. Because it burns off cleaner in a low-oxygen atmosphere, a methacrylic polymer is preferable over an acrylic polymer.

Within the above limitations for non-acidic comonomers, the alkyl acrylate or methacrylate in one embodiment constitutes at least 70 wt. %, and in another embodiment, at least 75 wt. %, of the polymer.

The non-carboxylic acid portion of the polymer binder, provided the above-mentioned compositional requirements and the following physical conditions are satisfied, may include, in place of the alkyl acrylate or methacrylate portion of the polymer, up to 50 wt. % of other non-acrylic and non-acidic comonomers, such as styrene, acrylonitrile, vinyl acetate, acrylamide, and aminoalkyl acrylates or methacrylates. However, it is preferable to use not more than 25 wt. % of such monomers because it may be more difficult to cleanly burn them off.

In addition to the above acrylic and methacrylic polymers, various polyolefins can be used, including, but not limited to, polyethylene, polypropylene, polybutylene, polyisobutylene and ethylene-propylene copolymers. Polyethers, which are polymers of lower alkylene oxides, such as polyethylene oxide, can also be used.

Water-processable binder polymers that may be used include water-soluble cellulose derivatives, for example, hydroxyethylcellulose, hydroxyethylmethylcellulose and hydroxypropylcellulose.

### Photocurable Monomer

The photocurable component includes addition polymerizable unsaturated monomer compounds having at least one polymerizable ethylenically unsaturated group. The monomer compounds can form high-molecular-weight polymers by free radical-initiated chain propagation addition polymerization. These monomer compounds are non-gaseous, that is, they have a normal boiling point higher than 100°C and a plasticizing action on organic polymer binders.

Suitable monomers that can be used individually or in combination with other monomers include: t-butyl acrylate and t-butyl methacrylate, 1,5-pentadiol acrylate and 1,5-pentadiol methacrylate, N,N-dimethylaminoethyl acrylate and N,N-dimethylaminoethyl methacrylate, ethylene glycol diacrylate and ethylene glycol dimethacrylate, 1,4-butanediol diacrylate and 1,4-butanediol dimethacrylate, diethylene glycol diacrylate and diethylene glycol dimethacrylate, hexamethylene glycol diacrylate and hexamethylene glycol dimethacrylate, 1,3-propanediol diacrylate and 1,3-propanediol dimethacrylate, decamethylene glycol diacrylate and decamethylene glycol dimethacrylate, 1,4-cyclohexanediol diacrylate and 1,4-cyclohexandiol dimethacrylate, 2,2-dimethylolpropane diacrylate and 2,2-dimethylolpropane dimethacrylate, glycerol diacrylate and glycerol dimethacrylate, tripropylene glycol diacrylate and tripropylene glycol dimethacrylate, glycerol triacrylate and glycerol trimethacrylate, trimethylolpropane triacrylate and trimethylolpropane trimethacrylate, pentaerythritol acrylate and pentaerythritol methacrylate, polyoxyethylated trimethylolpropane triacrylate and polyoxyethylated methylolpropane trimethacrylate, and similar compounds disclosed in U.S. Patent No. 3,380,831; 2,2-di(p-hydroxyphenyl)propane diacrylate, pentaerythritol tetraacrylate pentaerythritol tetramethacrylate, 2,2-di-(p-hydroxyphenyl)propane dimethacrylate, triethylene glycol diacrylate, polyoxyethyl-2,2-di-(p-hydroxyphenyl)propane dimethacrylate, the di-(3-methacryloxy-2-hydroxypropyl) ether of bisphenol A, the di-(2-methacryloxyethyl) ether of bisphenol A, the di-(3-acryloxy-2-hydroxypropyl) ether of bisphenol A, the di-(2-acryloxyethyl) ether of bisphenol A, the di-(3-methacryloxy-2-hydroxypropyl) ether of 1,4-butanediol, triethylene glycol dimethacrylate, polyoxypropyltrimethylolpropane triacrylate, butylene glycol diacrylate and butylene glycol dimethacrylate, 1,2,4-butanetriol triacrylate and 1,2,4-butanetriol trimethacrylate, 2,2,4-trimethyl-1,3-pentanediol diacrylate and 2,2,4-trimethyl-1,3-pentanediol dimethacrylate, 1-phenyl-1,2-ethylene dimethacrylate, diallyl fumarate, styrene, 1,4-benzenediol dimethacrylate, 1,4-diisopropenylbenzene and 1,3,5-triisopropenylbenzene. Ethylenically unsaturated compounds having a molecular weight of at least 300, such as alkylene or polyalkylene glycol diacrylates prepared from alkylene glycols of 2 to 15 carbons or polyalkylene ether glycols having 1 to 10 ether linkages, and the compounds disclosed in U.S. Patent No. 2,927,022, such as ones having a plurality of added ethylenically unsaturated bonds, particularly as end group bonds, can also be used.

The preferred monomers include polyoxyethylated trimethylolpropane triacrylate, ethylated pentaerythritol triacrylate, dipentaerythritol monohydroxypentaacrylate and 1,10-decanediol dimethylacrylate. The monomers are present in an amount, based on the total weight of the dried photopolymerizable layer, of 6 to 45 wt. %.

### Photoinitiator

Suitable photoinitiators include substituted and unsubstituted polycyclic quinones having two endocyclic carbons in a conjugated carbon ring system, such as 9,10-anthraquinone, 2-methylanthraquinone, 2-ethylanthraquinone, 2-tert-butylanthraquinone, octamethylanthraquinone, 1,4-naphthoquinone, 9,10-phenanthrenequinone, benz(a)anthracen-7,12-dione, 2,3-naphthacen-5,12-dione, 2-methyl-1,4-naphthoquinone, 1,4-dimethylanthraquinone, 2,3-dimethylanthraquinone, 2-phenylanthraquinone, 2,3-diphenylanthraquinone, retenequinone, 7,8,9,10-tetrahydronaphthacen-5,12-dione and 1,2,3,4-tetrahydrobenz(a)anthracen-7,12-dione. U.S. Patent No. 2,760,863 mentions other useful photoinitiators (even though some may be thermally active at temperatures below 85°C), which include vic-ketoaldonyl alcohols such as benzoin and pivaloin, acyloin ethers such as benzoin methyl ether and benzoin ethyl ether, and α-hydrocarbon-substituted aromatic acyloins such as α-methylbenzoin, α-allylbenzoin and α-phenylbenzoin. The photoreducible dyes and reducing agents mentioned in U.S. Patent Nos. 2,850,445, 2,875,047, 3,097,096, 3,074,974, 3,097,097 and 3,145,104; as well as dyes of the phenazine, oxazine and quinine classes. Michler's ketone, benzophenone, 2,4,5-triphenylimidazolyl dimmers with hydrogen donors including leuco dyes and mixtures thereof mentioned in U.S. Patent Nos. 3,427,161, 3,479,185 and 3,549,367, for example, may be also used as initiators. Also useful with photoinitiators are the photosensitizers disclosed in U.S. Patent No.4,162,162. The amount of photoinitiator present, based on the total weight of the dried photopolymerizable layer, is 0.05 to 10 wt. %.

### Dispersants

The dispersant is used to ensure sufficient wetting of the inorganic substances by the organic polymer and monomer. A completely dispersed inorganic substance is desirable in the preparation of a photoactive paste having the characteristics of: good screen printing and leveling and burn-off properties. The dispersant acts to allow the polymer binder to associate or wet the inorganic solids to provide a system free of agglomerates. A suitable dispersant includes the A-B dispersants described in "The Use of A-B Block Copolymers as Dispersants for Nonaqueous Coating Systems" by H.L. Jacubauskas, Journal of Coating Technology, Vol. 58, No. 736, pp. 71-82. Other useful A-B dispersants are mentioned in U.S. Patent Nos. 3,684,771, 3,788,998, 4,070,388 and 4,032,698, and in British Patent No. 1,339,930.

The photosensitive thick-film dielectric paste composition may contain a small amount of other ingredients, including pigments, dyes, thermal polymerization initiators, adhesion promoters, for example, organosilane coupling agents, plasticizers, and coating aids, for example, polyethylene oxide, provided the photopolymerizable composition maintains its desired characteristics. Organosilanes are particularly useful in an amount of up to 3.0 wt %, based on the weight of the inorganic particles. Treated particles have lower demand for organics, whereby the level of organic vehicle in the composition can be reduced, making burn-off during firing easier. Organosilanes also improve dispersibility and allow for a lower ratio of inorganic binder to ceramic solids as equivalent hermeticity.

### Processing

The photosensitive thick-film dielectric paste composition may be either in the form of a film that has already been applied to a substrate, or is applied to a substrate in the form of a paste by a conventional layer-forming method, e.g., screen printing.

A film utilizing the photosensitive thick-film dielectric paste composition may be formed by casting a thin layer of the composition onto a flexible substrate and heating the cast layer to remove the volatile organic solvent therefrom. Additionally, the solvent-free layer may be separated from the substrate. The film or paste composition may be used in the formation of an insulating layer used in flat panel displays. When formation is by a screen printing process, the printing and drying process may be repeated several times to obtain the desired dry film thickness.

It is advantageous for dielectric formation that the screen selected for use be one which has a relatively large coat-out rate, such as one made of SUS stainless steel and having a mesh size of 150 to 250. Drying may be carried out by either a hot air or infrared system, so long as the in-plane uniformity is good. The drying conditions depend also on the printed film thickness. Conditions under which a tack-free dry film can be obtained are used, such as 80 to 100°C for 10 to 20 minutes. The photopolymerizable dielectric composition is then imagewise exposed to actinic radiation thereby forming exposed areas and unexposed areas. Exposure is carried out using a system which is capable of irradiating ultraviolet light, and which uses as the light source a high-pressure mercury vapor lamp or an ultrahigh-pressure mercury vapor lamp. Drying can be carried out at an exposure energy of 50 to 400 mJ/cm² (@ 365 nm), although this also depends on the dielectric composition and the film thickness. The unexposed areas of the layer are removed by a process known as development.

During aqueous development with an aqueous solution containing 0.4 to 1.0 wt. % of sodium carbonate, the layer is removed in those portions which are not exposed to radiations, and the exposed portions remain substantially unaffected. Development times are those conventionally used for complete development. Development may be carried out with a conveyor-type developing machine having spray nozzles or by a dipping process. In a conveyor-type system, the development period is generally from several tens of seconds to several minutes. Additional processing steps may also be carried out before the firing operation, following which the organic components are removed by volatilization and the inorganic binder (glass frit) is sintered. The firing temperature is subject to limitations from the other components. For a Plasma Display Panel-Field Emission Display (PDP·FED) using a glass substrate, firing is generally carried out at 500 to 600°C (peak temperature). The composition is air-fireable in a substantially non-oxidizing atmosphere.

The invention will be further described in the following Examples, which are exemplary only, and do not limit the scope of the invention described in the claims.

### EXAMPLES

### EXAMPLES 1 and 2

In the following examples, unless noted otherwise, all parts and percent are by weight, and all degrees are Centigrade.

### Inorganic Substances

### Glass Frit: ground in water to a particle size range d₅₀ of 0.8 to 1.2 microns

Dried Lead Borosilicate Glass (Example 1):
Composition (component mol %): PbO (66), SiO₂ (23), B₂O₃ (8.5), Al₂O₃ (2.5)
Glass softening point = 525°C

Borosilicate Glass (Example 2):
Composition (component mol %): SiO₂ (7.1), Al₂O₃(2.1), B₂O₃(8.4), CaO(0.5), ZnO(12.0), Bi₂O₃(69.9)
Glass softening point=537°C

### Organic components

Polymer Binder: Copolymer of 75% methyl methacrylate and 25% methacrylic acid;
   M_{w} = 6,000; Tg = 136°C; acid value, 160
Solvent: TEXANOL (2,2,4-trimethyl-1,3-pentanediol monoisobutyrate)
Monomer: TEOTA 1000 (polyoxyethylated trimethylolpropane triacrylate; M_{w} = 1,162)
Initiators: EMK: ethyl Michler's ketone
   BP: benzophenone
Antioxidant: BHT (butylated hydroxyl toluene)
Stabilizer

### Preparation of Dielectric Paste Composition

### A. Preparation of Organic Vehicle:

The organic components (solvent and polymer binder) are heated at 135°C while being mixed and stirred. Heating and stirring are continued until the polymer binder dissolves to form a solution. The solution is cooled to 100°C, and then the initiators and stabilizer are added. The resulting mixture is stirred until the solid components are dissolved, after which the mixture is passed through a 400 mesh filter and cooled.

### B. Preparation of Dielectric Inorganic Substance-Glass Frit:

Eight kilograms of the glass frit Ferro 3467 is ground for 16 hours in a Sweco mill with 8 liters of water and using 0.5 inch diameter, 0.5 inch long alumina cylinders, achieving a d₅₀ particle size distribution of 2.3 to 2.7 microns. This frit water mixture is passed through a 400 mesh screen and passed through an S.G. Frantz model 241 F2 magnetic separator at a 11.5 V DC setting of 30 amperes.

Next, the glass frit mixture is freeze-dried using a Virtis Console 12 freeze dryer. This technique generally requires three days to remove all the water.

### C. Formulation of the Paste:

The dielectric paste is formulated by mixing the organic vehicle, monomer and dispersant in a mixing vessel under a yellow light. Next, the glass frit is added and the mixture is blended for 30 minutes. The resulting mixture is aged for 12 hours, and is then roll milled using a three-roll mill at a roll pressure of 400 psi. Generally, to completely mix the composition, it suffices to make 5 passes through the mill. Next, the paste composition is screened by being passed through a 400 mesh screen.

The paste viscosity at this time is adjusted from 20 to 120 P.S. by the addition of TEXANOL. This viscosity range is optimal for screen-printing.

The following represents the respective amounts in weight percent of the above formulation:

| **Example 1** | | **Example 2** |
|---|---|---|
| Glass frit: | Lead Borosilicate glass 50.0 wt.% | Borosilicate glass: 62.5 wt. % |
| Polymer binder: | 10.0 wt. % | 7.50 wt. % |
| Reactive monomer: | 6.0 wt. % | 4.50 wt. % |
| Initiator: | 2.0 wt. % | 1.50 wt. % |
| Stabilizer: | 0.01 wt. % | 0.0 wt. % |
| Solvent: | 31.99 wt. % | 24.0 wt. % |

The photosensitive glass paste composition of Example 1 was subjected to printing, drying, exposure and development processes, and the resulting patterned glass paste was fired. The shape and transparency of the samples were visually inspected. Representative parts for voltage resistance characteristics of the inventive composition were prepared by depositing FodeITM DC206 photoimageable AG conductor (E. I. du Pont de Nemours and Company, Wilmington, DE) by screen-printing on a glass substrate of soda-lime glass and preparing underlying conductor patterns having dimensions of 1 cm x 4cm and having a thickness after drying and firing at 530°C of 6 µ, preparing a dielectric layer having a dried thickness of 20 µ upon firing at 530°C, and, in addition, preparing a top strip patterned electrode having dimensions of 1 mm x 4mm and perpendicular to the underlying conductor pattern with screen-printing fireable Ag paste K3714 (E. I. du Pont de Nemours and Company, Wilmington, DE) by firing at 430°C. The voltage resistance of the dielectric layer in the representative parts was measured and exhibited resistance to 1500V.

The properties of the example of the lead-free composition of Example 2 would be similar to those indicated below in Table 1.

**Table 1-Example 1**

| | Firing Temperature (°C) | | | | |
|---|---|---|---|---|---|
| | 490 | 530 | 550 | 560 | 590 |
| Shape of fired dielectric | Non-trapezoid | Square to trapezoid | Trapezoid | Trapezoid | floated |
| Transparency | Hazy | clear | clear | clear | hazy |

Unless otherwise defined, all technical and scientific terms used herein have the same meaning as commonly understood by one of ordinary skill in the art. Although methods and materials similar or equivalent to those described herein may be used in the practice or testing of the invention, suitable methods and materials are described herein. In case of conflict, the present specification, including definitions, will control. In addition, the materials, methods, and examples are illustrative only and not intended to be limiting.

## Claims

1. A photosensitive thick-film dielectric paste composition, comprising:
(a) a glass frit having a glass softening point not lower than 0° to 40°C below a firing temperature ranging above 450°C and up to 600°C;
(b) an organic polymer binder;
(c) a photoinitiator;
(d) a photocurable monomer; and,
(e) an organic solvent, wherein the composition is aqueous-developable upon exposure to actinic radiation.

2. The composition of Claim 1, wherein the glass frit contains either a mixture, based on mole percent, of 66% PbO, 23% SiO₂, 8.5% B₂O₃, and 2.5% Al₂O₃ or no lead.

3. The composition of any of the preceding claims, wherein the composition is developable in a solution comprising sodium carbonate.

4. The composition of any of preceding claims, wherein the glass softening point of the glass frit is 5°C to 20°C below the firing temperature and the firing temperature is between 500°C to 600°C.

5. A method for forming an insulating layer in a display panel, comprising the steps of:
(a) providing a glass substrate;
(b) coating the substrate with a conductive thick film composition;
(c) firing the substrate and conductive composition of step (b) to form an electrode;
(d) printing a dielectric paste composition comprising a glass frit onto a surface of the electrode of step (c);
(e) imagewise exposing selected areas of the dielectric composition of step (d) with actinic radiation to form exposed and unexposed areas;
(f) developing the unexposed areas formed in step (e) in an aqueous medium; and
(g) firing the exposed dielectric paste composition of step (f) at a temperature ranging above 450°C and up to 600°C, wherein the glass softening point of the glass frit is not lower than 0°C to 40°C below the firing temperature.

6. The method of Claim 5, wherein the glass frit contains either a mixture, based on mole percent, of 66% PbO, 23% SiO₂, 8.5% B₂O₃, and 2.5% Al₂O₃ or no lead.

7. The method of Claims 5 or 6, wherein the aqueous medium comprises a solution of 0.4 to 1.0 wt % sodium carbonate.

8. The method of any of Claims 5 to 7, wherein the glass softening point of the glass frit is 5°C to 20°C below the firing temperature and the firing temperature is between 500°C to 600°C.

9. The method of any of Claims 5 to 8, wherein the dielectric paste composition after firing in step (g) has a thickness of 20 *µ*m.

10. An insulating layer formed by the method of any of claims 5 to 9.

11. The layer of Claim 10, wherein the layer has a thickness of 20*µ*m after the step of firing or the layer is transparent.

12. A flat panel display comprising the composition of Claim 1.

13. A flat panel display comprising an insulating layer formed according to the method of any of claims 5 to 8.
